Europäisches Patentamt

European Patent Office

Office européen des brevets

(19)

(11) EP 0 665 625 B1

(12) **EUROPÄISCHE PATENTSCHRIFT**

(45) Veröffentlichungstag und Bekanntmachung des Hinweises auf die Patenterteilung:
**02.09.1998 Patentblatt 1998/36**

(51) Int Cl.⁶: **H02H 7/26**, H02H 3/40, G01R 31/08

(21) Anmeldenummer: **95100593.3**

(22) Anmeldetag: **18.01.1995**

(54) **Verfahren zur Erzeugung eines Impedanzwertes und zu dessen Verarbeitung in einer Distanzschutzeinrichtung**

Method for obtaining an impedance value and for processing in a distance protection device

Procédé pour obtenir la valeur d'impédance et pour le traitement dans un dispositif de protection à distance

(84) Benannte Vertragsstaaten:
**AT BE DE ES GB IT NL SE**

(30) Priorität: **24.01.1994 DE 4401888**

(43) Veröffentlichungstag der Anmeldung:
**02.08.1995 Patentblatt 1995/31**

(73) Patentinhaber: **AEG Energietechnik GmbH 60528 Frankfurt (DE)**

(72) Erfinder:
• **Simon, Rudolf, Dr., Dipl.-Ing.**
  **D-55569 Monzingen (DE)**
• **Schegner, Peter, Dr.-Ing.**
  **D-63755 Alzenau (DE)**
• **Igel, Michael, Dr.-Ing.**
  **D-40880 Ratingen (DE)**

(74) Vertreter: **Dreiss, Fuhlendorf, Steimle & Becker, Patentanwälte**
  **Postfach 10 37 62**
  **70032 Stuttgart (DE)**

(56) Entgegenhaltungen:
• **THIRD INTERNATIONAL CONFERENCE ON DEVELOPMENTS IN POWER-SYSTEM PROTECTION (CONF. PUBL. NO.249), LONDON, UK, 17-19 APRIL 1985, 1985, LONDON, UK, IEE, UK, Seiten 188-192, KONDOW R ET AL 'Microprocessor-based fault locator'**
• **BROWN BOVERI REVIEW, OCT. 1969, SWITZERLAND, Bd. 56, Nr. 10, ISSN 0007-2486, UNGRAD H ET AL 'Verhalten von Distanzrelais bei Erdkurzsclüssen auf Doppelleitungen'**

## Beschreibung

Die Erfindung bezieht sich auf ein Verfahren zur Erzeugung eines Impedanzwerts und zu dessen Verarbeitung mit einer Distanzschutzeinrichtung, die unsymmetrische Energieübertragungsleitungen überwacht, wobei der Impedanzwert dem Abstand zwischen einem Fehlerort und einem Meßort proportional ist, an dem die Ströme und Spannungen der Übertragungsleitungen gemessen werden.

Energieübertragungsleitungen ohne Verdrillung der Phasenleiter zur Symmetrierung sind wirtschaftlicher herzustellen. Mit dem Erstellen unsymmetrischer Übertragungsleitungen tritt bei Schutzrelais für diese Leitungen das Problem einer genauen Erfassung der Abstände von Fehlern wie Kurzschlüssen oder Erdschlüssen vom Meßort auf. Unsymmetrische Leitungen können durch symmetrische 3 × 3 Impedanzmatrizen beschrieben werden, die entweder gemessen oder aus der Leitungsgeometrie berechnet werden können. Bei einer Leitungssymmetrie hängt die Kurzschlußimpedanz von der Fehlerart und dem Meßkreis ab. Der herkömmliche Distanzschutz beruht auf der Annahme einer symmetrischen Leitung. Bei der Verwendung herkömmlicher Distanzschutztechniken ergibt sich eine Ungenauigkeit im Auslösebereich. Um Falschauslösungen zu vermeiden, müssen die Distanzschutzrelais auf geringere Abstände eingestellt werden.

Eine Verbesserung der Distanzmessung ist möglich, wenn der Impedanzberechnungsalgorithmus auf dem vollständigen Modell der unsymmetrischen Leitung beruht. Der Imbedanzberechnungsalgorithmus für den Schutz symmetrischer Leitungen geht von der Summenstromkompensation aus. Für unsymmetrische Leitungen kann eine Leiterstromkompensation verwendet werden, die innerhalb der Meßgenauigkeit exakt ist.

Distanzschutzrelais messen nur die örtlich vorhandenen Ströme und Spannungen, um Fehler zu erfassen und die Leitungen selektiv abzuschalten. Aufgrund der Relais-Zeitcharakteristik werden weiterführende Leitungen ebenfalls geschützt. Das Kriterium für die Fehlerortsfeststellung ist die Impedanz, die unter idealen Verhältnissen gleich der Leitungsimpedanz zwischen Meßort und Fehlerort ist.

Ideal sind folgende Verhältnisse:

- stationäre sinusförmige Ströme und Spannungen nur mit Netzfrequenz;
- metallischer Kurzschluß und
- genaue Kenntnis der Leitungsimpedanz.

Die tatsächlichen Werte werden durch Netzeinflüsse, wie Harmonische, Gleichstromkomponenten oder übertragungsfehler z. B. Stromwandlersättigung oder Schwingungen kapazitiver Spannungswandler verfälscht. Infolgedessen ist die berechnete Impedanz falsch, wobei der Fehler von dem verwendeten Algorithmus abhängt. Dieser Sachverhalt wird signalbedingte Unschärfe der Distanzschutzeinheiten genannt.

Lichtbögen und Erdübergangswiderstände an den Fehlerorten beeinträchtigen die gemessenen Spannungen. Die Grundfrequenz kann durch die Fehlerwiderstände in Betracht gezogen werden. Diese wiederum können als apriori unbekannte Netzelemente berücksichtigt werden. Infolgedessen hängt die berechnete Impedanz vom Zustand des Energieübertragungssystems ab. Das gleiche Problem entsteht bei Zwischeneinspeisung unter Berücksichtigung von Fehlern auf Folgeleitungen. Analog zur signalbedingten Unschärfe wird dies systembedingte Unschärfe genannt.

Ein exaktes Leitungsmodell und die Kenntnis der aktuellen Parameter sind Voraussetzungen für die richtige Fehlerlokalisierung. Für die Einstellung von Distanzschutzeinheiten wird das Modell einer symmetrischen Leitung benutzt, obwohl vorhandene Leitungen unsymmetrisch sind. Daher ist die modellbedingte Unschärfe unvermeidlich.

Für eine symmetrische Leitung ist eine entkoppelte Darstellung der drei Phasen durch symmetrische Komponententransformation möglich. Die Drehstromleitung wird durch ihre Mit-, Gegen- und Nullsystemimpedanzen dargestellt, von denen die ersten und zweiten identisch sind.

Für die Kurzschlußberechnung müssen die drei Komponenten am Fehlerort in Abhängigkeit von der Art des Fehlers verbunden werden.

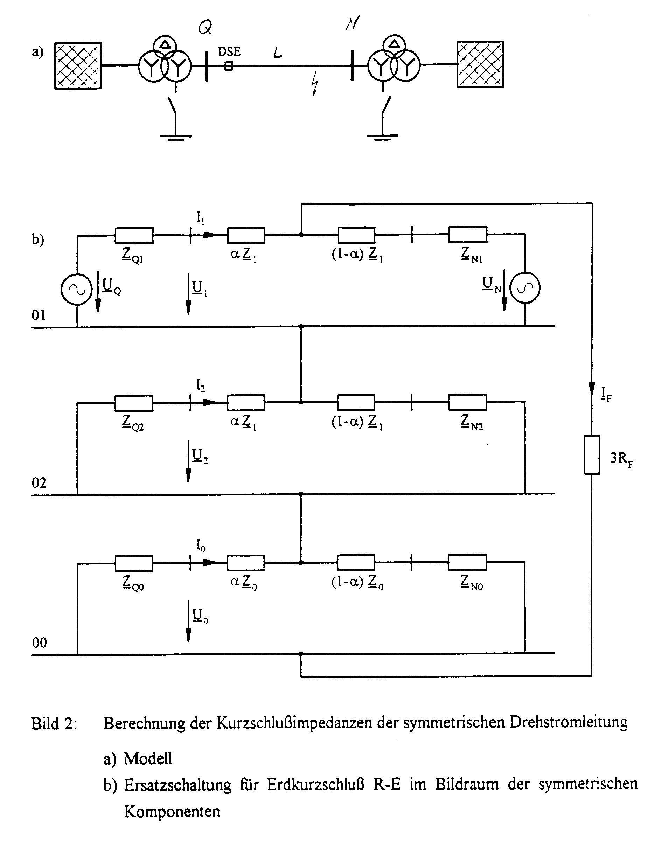

Die Analyse des Mitsystems reicht für dreiphasige Fehler aus. Bei unsymmetrischen Fehlern müssen die Komponentennetzwerke in Abhängigkeit von der Fehlerart verbunden werden. Das Bild 2 der Zeichnung zeigt dies für den Erdschluß der Phase R(R-E), der detaillierter im folgenden erörtert wird.

Für die Leiter-Erd-Spannung am Distanzschutzeinbauort gilt:

$$\underline{U}_{RE} = \underline{U}_1 + \underline{U}_2 + \underline{U}_0$$

$$= \alpha \underline{Z}_1 \underline{I}_1 + \alpha \underline{Z}_1 \underline{I}_2 + \alpha \underline{Z}_0 \underline{I}_0 + 3R_F \underline{I}_F$$

$$= \alpha \underline{Z}_1 \underline{I}_R + \alpha (\underline{Z}_0 - \underline{Z}_1) \underline{I}_0 + 3R_F \underline{I}_F \qquad (1)$$

worin mit $U_{RE}$ die Leiter-Erdspannung an Distanzschutzrelais, mit $\underline{U}_1$ die Mitsystemspannung, mit $\underline{U}_2$ die Gegensystemspannung, mit $\underline{U}_0$ die Nullsystemspannung, mit $\alpha$ der der auf die Leitungslänge bezogene Abstand zwischen Distanzrelais und Fehler, mit $\underline{Z}_1$ die Mitsystemimpedanz, mit $\underline{I}_1$ der Mitsystemstrom, mit $\underline{I}_2$ der Gegensystemstrom, mit $\underline{I}_0$ der Nullsystemstrom, mit $\underline{Z}_0$ die Nullsystemimpedanz, mit $\underline{I}_F$ der Fehlerstrom und mit $R_F$ der Fehlerwiderstand bezeichnet sind.

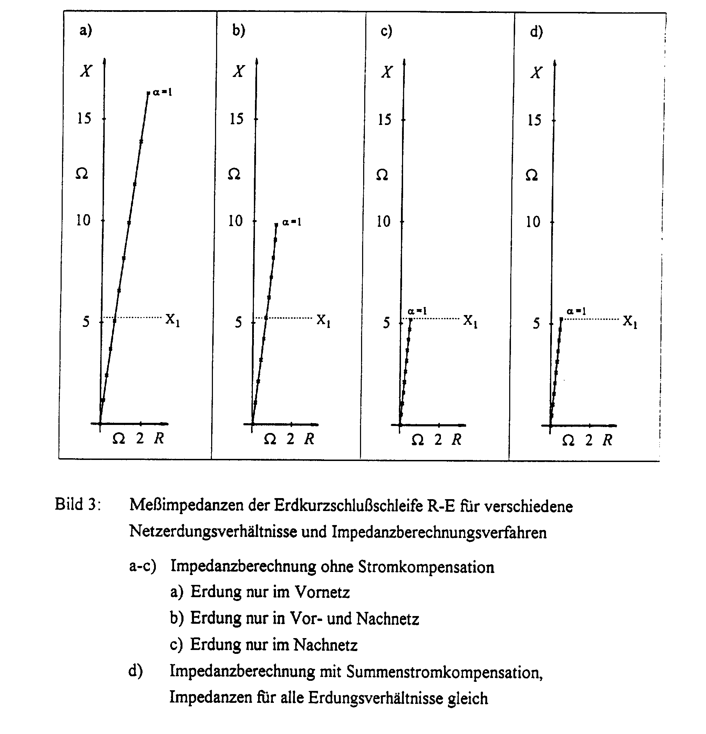

Bei einem metallischen Kurzschluß ($R_F = 0$) ist der Strom am entfernten Ende ohne unmittelbaren Einfluß auf die gemessene Spannung. Da aber die Mitsystem- und Nullsystemimpedanzen normalerweise verschieden sind, ist der Summenstrom $\underline{I}_0$ von Bedeutung. Der Wert von $\underline{I}_0$ hängt von der Erdung ab und ist zwischen $\underline{I}_0 = 0$ (nur das entfernte Netz ist geerdet) und $\underline{I}_0 = \underline{I}_F$ (nur das vorgeschaltete Netz ist geerdet) veränderlich. Da die direkt berechnete Impedanz $\underline{Z}_{RF}$ von der Netzerdung abhängt, besteht keine Proportionalität zwischen dieser Impedanz und dem Fehlerort (Bilder 3a bis 3c).

Es gilt die Beziehung:

$$\underline{Z}_{RE} = \frac{\underline{U}_{RE}}{\underline{I}_R} \neq \alpha \underline{Z}_1 \qquad (2)$$

Deshalb kann diese Impedanz nicht als Auslösekriterium verwendet werden. Um diese Schwierigkeit zu beseitigen, muß ein komplexer, gewichteter Teil des Summenstroms jedem Phasenstrom nach folgender Beziehung hinzugefügt werden:

$$\underline{I}_{R\Sigma} = \underline{I}_R + \underline{k}_E \underline{I}_E \qquad (3)$$

worin $\underline{I}_{R\Sigma}$ der kompensierte Strom der Phase R ist und für $\underline{k}_E$ und $\underline{I}_E$ folgende Gleichungen gelten:

$$\underline{k}_E = \frac{1}{3} \frac{\underline{Z}_0 - \underline{Z}_1}{\underline{Z}_1} \qquad (4)$$

$$\underline{I}_E = 3\underline{I}_0 = \underline{I}_R + \underline{I}_S + \underline{I}_T \qquad (5)$$

Hieraus ergibt sich die Impedanz:

$$\underline{Z}_{RE\Sigma} = \frac{\underline{U}_{RE}}{\underline{I}_{R\Sigma}} = \alpha \underline{Z}_1 + 3R_F \frac{\underline{I}_F}{\underline{I}_{R\Sigma}} \qquad (6)$$

Bild 3d zeigt die mit der vorstehend angegebenen Gleichung berechnete Ortskurve der Kurzschlußimpedanzen. Diese sog. Summenstromkompensation ist für alle Distanzschutzrelais Stand der Technik (Ungrad, Winkler, Wiszniewski: Schutztechnik in Elektroenergiesystemen, Springer Verlag Berlin, N. Y., Heidelberg, 1992). Bei symmetrischen Leitungen ist die resultierende Impedanz für alle Arten von Fehlern richtig. Eine Übertragung des Modells auf unsymmetrische Leitungen ergibt die Leiterstromkompensation, die im folgenden beschrieben wird.

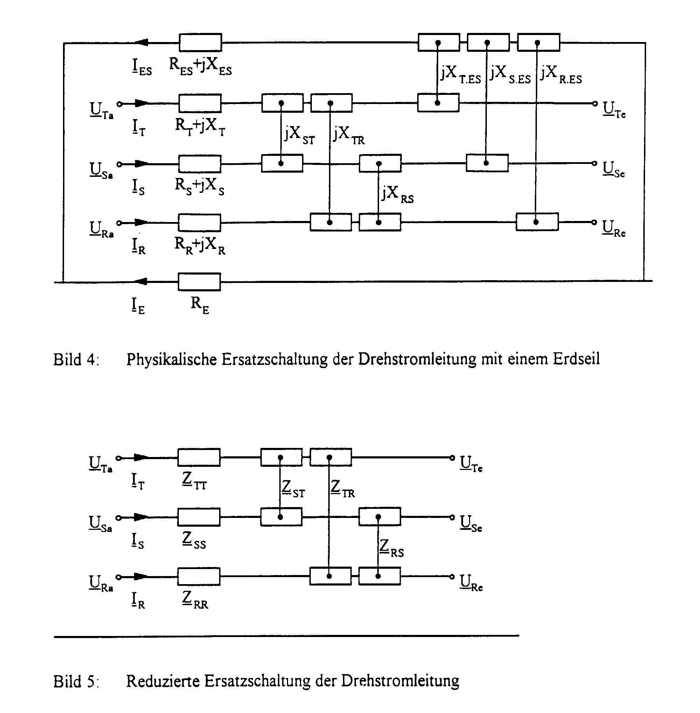

Die Leitungskonfiguration und das Leitermaterial bestimmen die Eigen- und die Kopplungsimpedanzen. Bild 4 zeigt die äquivalente Schaltung. Für die Berechnung werden folgende Annahmen getroffen:

1. Alle Leiter jeder Leitung müssen gleich sein.

2. Bündelleiter werden durch ihren äquivalenten Radius dargestellt.

$$r_{eq} = \sqrt[n]{n \, r \, r_B^{n-1}} \qquad (7)$$

Der äquivalente Widerstand ist $R'_{eq} = \frac{R'}{n}$, wobei mit n die Zahl der Seile pro Bündel, mit r der Seilradius und mit $r_B$ der Radius des Teilkreises bezeichnet ist.

3. Lineare, zeit- und längs der Leitung ortsinvariante Materialien:

Konstanter Widerstandsbelag R',
Konstante Leiter- und Erdpermeabilität $\mu$;,
Konstanter spezifischer Erdwiderstand $R_E \approx \frac{\omega\mu_0}{8} = 0{,}049 \frac{\Omega}{km} (f = 50Hz)$.

4. Unveränderte Leitungsverdrillung über die gesamte Länge (1), keine Leitungsverdrillung.
Dann sind die äquivalenten Elemente:

Leitungswiderstand:

$$R_R = l\,R_R' \tag{8}$$

Leitungsreaktanz:

$$X_R = l\frac{\omega\mu_0}{2\pi}(\ln\frac{\delta}{r_R} + \frac{\mu_r}{4n}) \tag{9}$$

Koppelreaktanz:

$$X_{RS} = l\frac{\omega\mu_0}{2\pi}\ln\frac{\delta}{d_{RS}} = X_{SR} \tag{10}$$

Um die äquivalente Schaltung zu vereinfachen, können zwei Bedingungen in Betracht gezogen werden:

1. Entsprechend dem Kirchhoffschen Gesetz muß die Summe aller fünf Ströme gem. Bild 3 null sein:

$$\Sigma\underline{I} = \underline{I}_R + \underline{I}_S + \underline{I}_T - \underline{I}_E - \underline{I}_{ES} = 0 \tag{11}$$

2. Da die Erdleitungen an jedem Mast geerdet sind, ist der Spannungsabfall der gleiche wie längs der Erde:

$$\Delta\underline{U}_{ES} = 0 \Leftrightarrow$$

$$\underline{I}_{ES} = \frac{R_E + jX_{R.ES}}{R_E + R_{ES} + jX_{ES}}\underline{I}_R + \frac{R_E + jX_{S.ES}}{R_E + R_{ES} + jX_{ES}}\underline{I}_S + \frac{R_E + jX_{T.ES}}{R_E + R_{ES} + jX_{ES}}\underline{I}_T \tag{12}$$

Die Eliminierung der Erdleitungen ergibt die übliche Dreileiterdarstellung von Energieleitungen, die in Bild 5 dargestellt sind. Der Spannungsabfall $\Delta U$ längs der Leitung hängt von den Phasenströmen und der Leitungsimpedanzmatrix ab:

$$\Delta\underline{\mathbf{U}} = \begin{bmatrix} \Delta\underline{U}_R \\ \Delta\underline{U}_S \\ \Delta\underline{U}_T \end{bmatrix} = \begin{bmatrix} \underline{Z}_{RR} & \underline{Z}_{RS} & \underline{Z}_{RT} \\ \underline{Z}_{SR} & \underline{Z}_{SS} & \underline{Z}_{ST} \\ \underline{Z}_{TR} & \underline{Z}_{TS} & \underline{Z}_{TT} \end{bmatrix} \cdot \begin{bmatrix} \underline{I}_R \\ \underline{I}_S \\ \underline{I}_T \end{bmatrix} = \underline{\mathbf{Z}} \cdot \underline{\mathbf{I}} \tag{13}$$

$$\underline{Z}_{RR} = R_E + R_R + jX_R - \frac{(R_E + jX_{R.ES})^2}{R_E + R_{ES} + jX_{ES}}$$

$$\underline{Z}_{RS} = R_E + jX_{RS} - \frac{(R_E + jX_{R.ES})(R_E + jX_{S.ES})}{R_E + R_{ES} + jX_{ES}} = \underline{Z}_{SR}$$

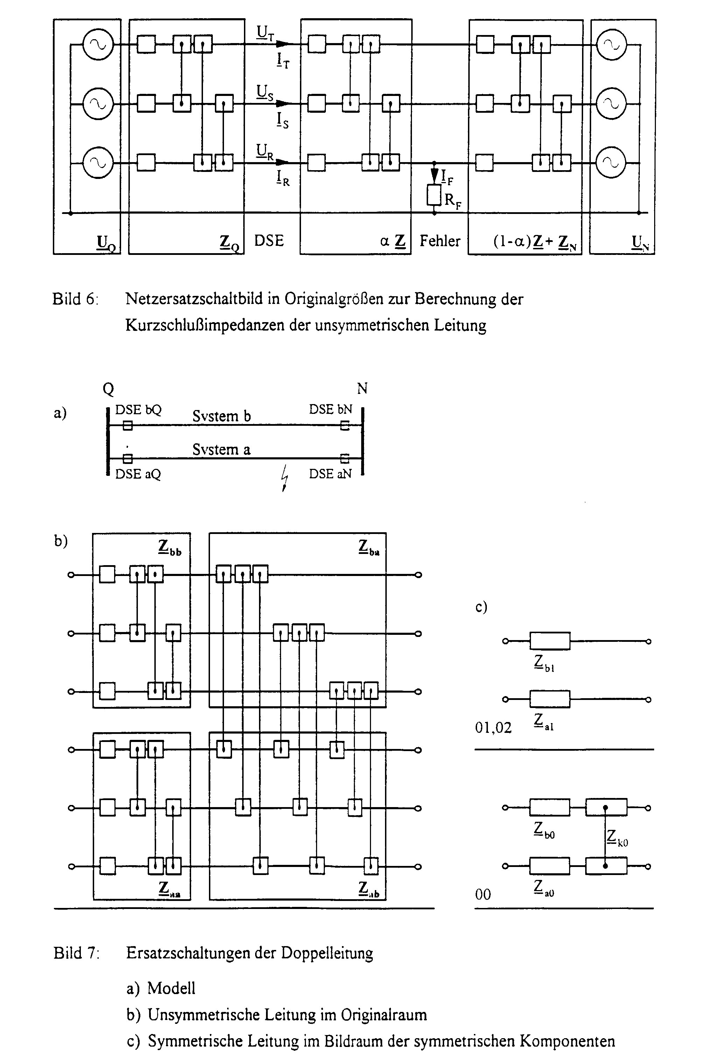

$\underline{Z}$ ist eine symmetrische 3 × 3-Matrix. Die Verschiedenheit der Diagonalelemente resultiert aus den unterschiedlichen Abständen zwischen Erd- und Leiterseilen. Zusätzlich hängen die Unterschiede der Nichtdiagonal-Elemente von den Leiterabständen ab. Die Kurzschlußberechnung findet unter den gleichen Netzbedingungen statt wie im Fall einer symmetrischen Leitung (Bild 2a). Bild 6 zeigt die dreiphasige Ersatzschaltung mit Originalelementen. Aus dieser können die Kurzschlußspannungen direkt, d. h. für den Erdkurzschluß (R-E) wie folgt gewonnen werden:

$$\underline{U}_{RE} = \alpha \cdot (\underline{Z}_{RR}\underline{I}_R + \underline{Z}_{RS}\underline{I}_S + \underline{Z}_{RT}\underline{I}_T) + R_F\underline{I}_F \tag{14}$$

Analog der Definition der Summenstromkompensationstechnik muß ein Strom als gewichtete Summe aller drei Phasenströme in der Weise berechnet werden, daß die Impedanzen der Fehlerentfernung proportional werden. Für den gewichteten Strom gilt die Gleichung:

$$\underline{I}_{RP} = \frac{\underline{Z}_{RR}}{\underline{Z}_b}\,\underline{I}_R + \frac{\underline{Z}_{RS}}{\underline{Z}_b}\,\underline{I}_S + \frac{\underline{Z}_{RT}}{\underline{Z}_b}\,\underline{I}_T \tag{15}$$

Hieraus folgt die Impedanz:

$$\underline{Z}_{REP} = \frac{\underline{U}_{RE}}{\underline{I}_{RP}} = \alpha \cdot \underline{Z}_b + R_F\frac{\underline{I}_F}{\underline{I}_{RP}} \tag{16}$$

Im Prinzip kann jede Referenzimpedanz $\underline{Z}_b \neq 0$ gewählt werden, aber aus offensichtlichen Gründen wird die Mitimpedanz ($\underline{Z}_b = \underline{Z}_1$ ; Definition von $\underline{Z}_1$ für unsymmetrische Leitungen wird weiter unten noch angegeben) bevorzugt. Die Verallgemeinerung der Gleichung für $\underline{I}_{RP}$ ist eine komplexe Abbildung des mathematischen Vektors der gemessenen Ströme $\underline{I}$ in die brauchbaren Auswerteströme $\underline{I}_P$.

$$\underline{I}_P = \frac{1}{\underline{Z}_b} \cdot \underline{Z} \cdot \underline{I} = \underline{K}_P \cdot \underline{I} \tag{17}$$

Um die genauen Impedanzen zu berechnen, muß eine Stromkompensation vorgenommen werden. Die Summenstrom-Kompensation ist Stand der Technik, jedoch ergibt diese bei unsymmetrischen Leitungen ziemlich schlechte Ergebnisse. Die Leiterstrom-Kompensation ist genau, aber benötigt umfangreiche, komplexe Berechnungen.

Hier setzt die Erfindung ein, der das Problem zugrunde liegt, ein Verfahren zur Bestimmung einer der Fehlerdistanz auf unsymmetrischen Starkstromleitungen proportionalen Impedanz mit geringem Aufwand und hoher Genauigkeit zu entwickeln.

Das Problem wird erfindungsgemäß dadurch gelöst, daß eine Sunmenstronkompensationsmatrix $\underline{\mathbf{K}}_\Sigma$ mit Hilfe der Summenstromgleichung nach folgenden Beziehungen gebildet wird:

$$\underline{\mathbf{I}}_\Sigma = \underline{\mathbf{I}} + \underline{k}_E\,\underline{I}_E \begin{pmatrix} 1 \\ 1 \\ 1 \end{pmatrix} = \underline{\mathbf{K}}_\Sigma \underline{\mathbf{I}}$$

$$\underline{\mathbf{K}}_\Sigma = \mathbf{E} + \underline{k}_E\mathbf{F}$$

wobei

$$\mathbf{E} = \begin{pmatrix} 1 & 0 & 0 \\ 0 & 1 & 0 \\ 0 & 0 & 1 \end{pmatrix}; \quad \mathbf{F} = \begin{pmatrix} 1 & 1 & 1 \\ 1 & 1 & 1 \\ 1 & 1 & 1 \end{pmatrix}$$

daß die Summenstrom-Kompensationsmatrix $\underline{K}_\Sigma$ in die exakte Phasenstromkompensationsmatrix durch den Ersatz der Einheitsmatrix E mit einer komplexen, symmetrischen Korrekturmatrix $\Delta\,\underline{K}$ nach folgender Beziehungen umgewandelt wird, so daß die Summenstrom- und die Phasenstromkorpensationsmatrizen gleich sind:

$$\underline{K}_P = \Delta\underline{K} + \underline{k}_E F \qquad (18)$$

$$\Delta\underline{K} = \underline{K}_P - \underline{k}_E F \qquad (19)$$

worin mit $\underline{\textbf{K}}_\textbf{P}$ die Leiterstromkompensationsmatrix bezeichnet ist, daß die Impedanzen nach dem Summenstromverfahren mit der Korrekturmatrix wie folgt bestimmt wird:

$$\underline{I}_a = (\Delta K + \underline{k}_E F) \cdot \underline{I} \qquad (20)$$

und daß die Impedanz in der Distanzschutzeinrichtung mit gespeicherten Referenzgrößen verglichen wird, um in Abhängigkeit vom Vergleichsergebnis einen Leistungsschalter auszulösen oder nicht auszulösen, an den die Energieübertragungsleitungen angeschlossen sind. Die Distanzschutzeinrichtung führt eine Distanz- und Richtungsmessung mit ausgewählten Spannungs- und Strommeßwerten aus. Die sekundären Leiterströme und Spannungen von Anlagenwandlern werden in der Distanzschutzeinrichtung auf normierte Pegel umgesetzt. Mit diesen Strömen werden auf die oben beschriebene Weise die Ströme $\underline{I}a$ bestimmt, anhand derer die Impedanzen nach Gleichung (16) berechnet werden. Die Impedanzen werden mit in der Distanzschutzeinrichtung voreingestellten Werten von Distanzzonen verglichen.

In der Distanzschutzeinrichtung sind im allgemeinen mehrere Werte, d. h. Distanzzonen eingestellt, denen jeweils eine einstellbare Zeitstufe zugeordnet ist. Die Zeitstufen werden mit der Anregung der Distanzschutzeinrichtung gestartet. Liegt die festgestellte Impedanz innerhalb einer der eingestellten Impedanzzonen, erfolgt nach Ablauf der zugeordneten Zeit ein Distanzentscheid.

Vorzugsweise wird die komplexe Korrekturmatrix durch reelle Faktoren angenähert. Insbesondere werden die kleinen imaginären Anteile vernachlässigt und die Korrekturmatrix wie folgt bestimmt:

$$K = \text{Re}\,\{\Delta\underline{K}\} \qquad (21)$$

Bei der Bestimmung der fehlerdistanzproportionalen Impedanzen nach dem oben beschriebenen Verfahren ist der Aufwand relativ gering. Die Impedanzen können daher in kurzer Zeit nach Eintritt eines Fehlers bestimmt werden, wodurch die Zeit für das Auslösen der Leistungsschalter nicht in unerwünschter Weise vergrößert wird.

Die Impedanzmatrixberechnung (Gleichungen 7 - 13) läßt sich auf jede parallel ausgebildete Mehrfachleitung ausdehnen. Doppelleitungen werden durch eine symmetrische $6 \times 6$-Impedanzmatrix beschrieben, die in vier $3 \times 3$-Submatrizen aufgespalten werden kann nach der Beziehung:

$$\underline{Z} = \begin{pmatrix} \underline{Z}_{aa} & \underline{Z}_{ab} \\ \underline{Z}_{ba} & \underline{Z}_{bb} \end{pmatrix} \qquad (22)$$

Das dieser Impedanzmatrix zugrunde liegende Ersatzschaltbild ist in Bild 7b dargestellt. Bei einer symmetrischen Doppelleitung werden nur die gegenseitigen Kopplungen des Nullsystems berücksichtigt, wie dies in Bild 7c dargestellt ist.

Die Schaltzustände der Doppelleitung können sich im Betrieb des Starkstromsystems z. B. aufgrund von Schalterauslösungen ändern. In bezug auf das Distanzrelais DSEaQ im System a müssen drei Schaltzustände des Parallelsystems b in Betracht gezogen werden:

1. System b parallelgeschaltet.
2. System b geerdet.
3. System b offen, d. h. das System a kann als Einfachleitung behandelt werden.

Um eine falsche Auslösung zu vermeiden, müssen entweder die aktuellen Ströme oder wenigstens der Schaltzustand des Parallelsystems berücksichtigt werden.

Die Summenstromkompensationstechnik erfordert eine symmetrische Ersatzleitung (Ersatzschaltung nach Bild 7c). Um richtige Impedanzen zu berechnen, muß der Summenstrom wie folgt in Betracht gezogen werden:

$$\underline{I}_{aR\Sigma} = \underline{I}_{aR} + \underline{k}_{aE}\underline{I}_{aE} + \underline{k}_{kE}\,\underline{I}_{bE} \tag{23}$$

mit

$$\underline{k}_{aE} = \frac{1}{3}\frac{\underline{Z}_{a0} - \underline{Z}_{a1}}{\underline{Z}_{a1}}\ ;\ \underline{k}_{kE}\ \frac{1}{3}\frac{\underline{Z}_{k0}}{\underline{Z}_{a1}}$$

Auch hier kann das beschriebene, gemischte Kompensationsverfahren (Gleichung 20) mit Vorteil eingesetzt werden:

$$\underline{I}_{aG} = (\Delta\underline{K} + \underline{k}_{aE}\cdot F)\cdot\underline{I}_{a} + (\underline{k}_{KE}\cdot F)\cdot\underline{I}_{b} \tag{24}$$

Für die vollständige Kompensation müssen alle sechs Leiterströme berücksichtigt werden. Wenn der Fehler im System a vorhanden ist, muß der kompensierte Strom wie folgt berechnet werden:

$$\underline{I}_{aP} = \frac{1}{\underline{Z}_{b}}\cdot(\underline{Z}_{aa}\cdot\underline{I}_{a} + \underline{Z}_{ab}\cdot\underline{I}_{b}) = \underline{K}_{aP}\cdot\underline{I}_{a} + \underline{K}_{abP}\cdot\underline{I}_{b} \tag{25}$$

Die Genauigkeit dieser drei Berechnungsverfahren werden in einem Ausführungsbeispiel später gezeigt.

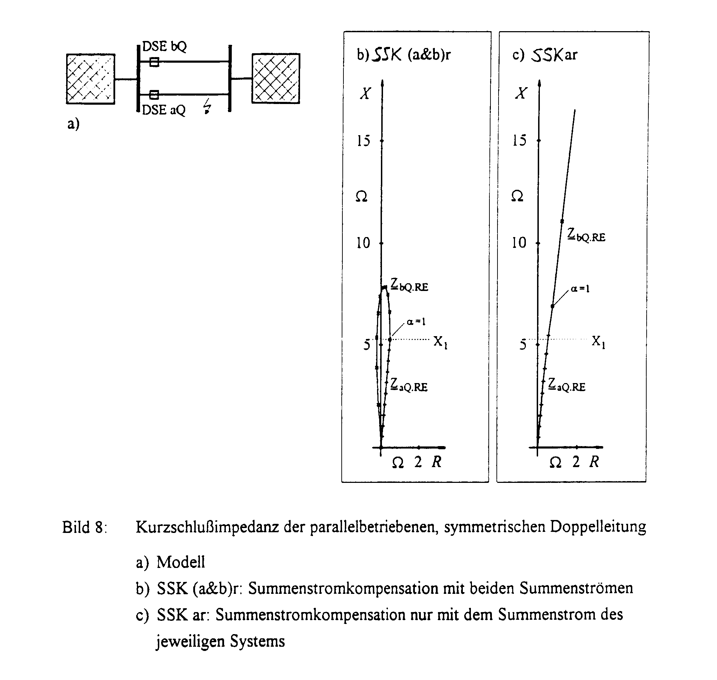

Die Berechnungsmethoden dürfen nur bei den Strömen des fehlerbehafteten Systems angewendet werden. Deshalb kann man sie "bedingte" Kompensationen nennen. Wenn beispielsweise der Summenstrom des fehlerbehafteten Systems den Leiterströmen des intakten Systems hinzugefügt wird, ist die Impedanz zu klein für Nahkurzschlüsse, wie aus Bild 8 zu ersehen ist. Wenn die Impedanz in die erste Zone läuft, erfolgt ein falsches Auslösen des intakten Systems. Um dies zu vermeiden, muß zuerst festgestellt werden, in welchem System der Fehler vorhanden ist. Dies geschieht durch einen Stromvergleich, der im folgenden näher beschrieben wird:

Die Kurzschlußströme hängen immer vom Betriebspunkt des Starkstromsystems ab. Deshalb ist im Falle von Einfachleitungen eine Fehlerlokalisierung nur mittels Strömen unzureichend. Im Gegensatz hierzu können an jedem Ende einer parallelen Doppelleitung zwei Ströme gemessen und miteinander verglichen werden. Die Differenz in Größe und Phase (Richtung) ergibt die Aussage über das System, das vom Fehler betroffen ist.

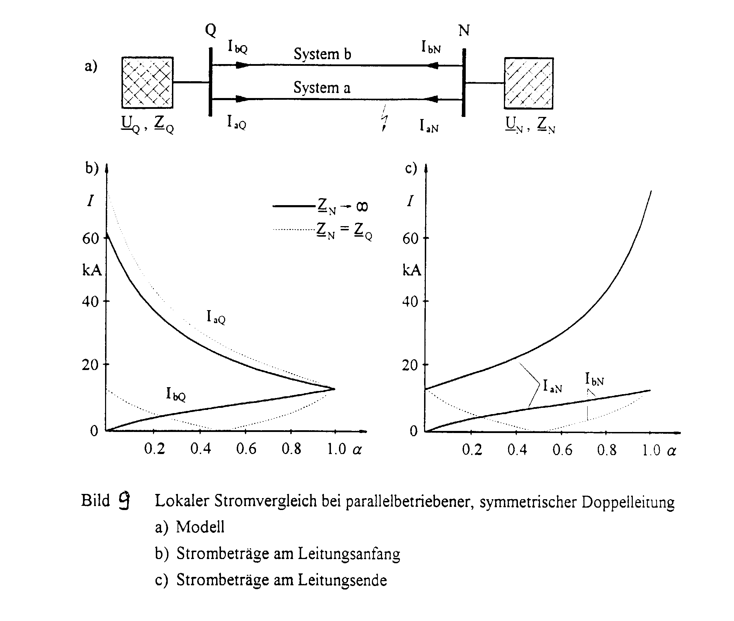

Es folgt aus den Strömen am Anfang der in Bild 9a dargestellten Leitung:

$I_{aQ} > I_{bQ}$ : Kurzschluß im System a,

$I_{aQ} < I_{bQ}$ : Kurzschluß im System b und

$I_{aQ} = I_{bQ}$ : Kurzschluß nicht auf der Doppelleitung.

Für den kritischen Fall der Doppelleitung ohne Last ($Z_N \rightarrow 00$) ist dieses Verhältnis ohne Nachweis am Leitungsende (Sammelschiene N in Bild 9). In diesem Fall sind die beiden gemessenen Strombeträge gleich für jede beliebige Fehlerstelle ($I_{aN} = I_{bN}$). Daher ist ein Richtungsvergleich notwendig. Wenn der Kurzschluß im System a vorliegt, fließt der Strom $I_{bN}$ zur Sammelschiene N, während der Strom $I_{aN}$ von der Sammelschiene N zum Fehlerort fließt. Die gleiche Bedingung gilt für eine passive Last an Sammelschiene N, die überlagerte Lastströme verursacht. Wenn die Doppelleitung von beiden Enden gespeist wird, ist die von dem Größenverhältnis abhängige Entscheidung immer ohne Fehler.

Veränderliche Variablen des Ersatzschaltbildes, d. h. Fehlerwiderstand, Leitungsimpedanz, Quellenspannungen, verursachen veränderliche Ströme. Dies wirkt sich nicht auf die Stromvergleichstechnik aus, da beide Ströme jeder Phase in gleicher Weise beeinflußt werden. Nur wenn die Leitungen nicht symmetrisch am Mast angeordnet sind, unterscheiden sich die Kurzschlußströme in jedem Phasenpaar aufgrund ihrer verschiedenen Leitungs- und Koppelimpedanzen. Diese Differenz kann durch eine komplexe Stromkorrektur beseitigt werden. Die Korrekturmatrix $\underline{K}_{I}$ ist streng nur im Falle von Kurzschlüssen am Leitungsende gültig, der Fall, für den sie abgeleitet wird. Aber das Vorliegen irgend eines anderen Fehlerortes gefährdet nicht die Selektivität des Stromvergleichs. Der Spannungsabfall ($\Delta\underline{U}$) längs der Doppelleitung kann mit den Strömen am Leitunganfang wie folgt ausgedrückt werden:

EP 0 665 625 B1

$$\Delta \underline{U} = \underline{Z}_{aa}\underline{I}_{aQ} + \underline{Z}_{ab}\underline{I}_{bQ} = \underline{Z}_{ba}\underline{I}_{aQ} + \underline{Z}_{bb}\underline{I}_{bQ}$$

$$\Rightarrow \underline{Z}_{a}\underline{I}_{aQ} = \left(\underline{Z}_{aa} - \underline{Z}_{ba}\right)\underline{I}_{aQ} = \left(\underline{Z}_{bb} - \underline{Z}_{ab}\right)\underline{I}_{bQ} = \underline{Z}_{b}\underline{I}_{bQ}$$

$$\Rightarrow \underline{I}_{aQ} = \left(\underline{Z}_{a}^{-1}\cdot\underline{Z}_{b}\right)\underline{I}_{bQ} = \underline{K}_{I}^{-1}\underline{I}_{bQ} \qquad (26)$$

$$\Rightarrow \underline{I}_{aQk} = \underline{K}_{I}\underline{I}_{aQ} = \underline{I}_{bQ}$$

$$\Rightarrow \underline{K}_{I} = \left(\underline{Z}_{a}^{-1}\cdot\underline{Z}_{b}\right)^{-1} \qquad (27)$$

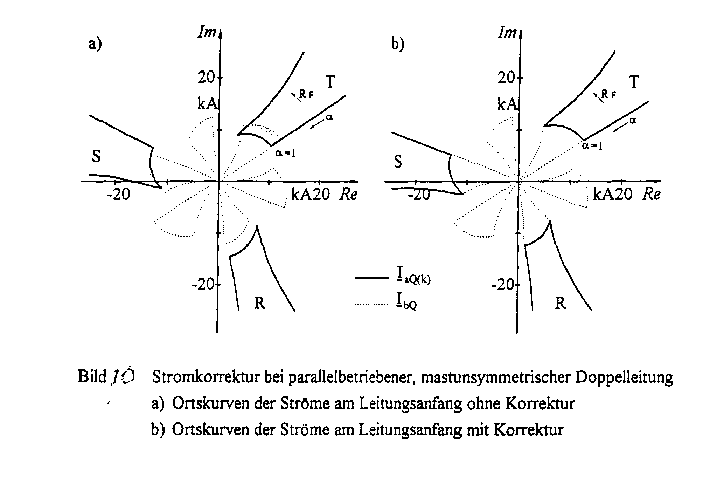

Bild 10 zeigt die Orstkurven der komplexen Stromzeiger für den Fall der mastunabhängigen symmetrischen Doppelleitung. Die Leitung wird von beiden Enden gespeist. System a hat einen dreiphasigen Kurzschluß (k3E). Variable sind der Fehlerort $\alpha$ und der Kurzschlußwiderstand $R_F$. Bei den Phasen S und T sind überlappende Bereiche für die Fehler am Leitungsende zu ersehen. Im Gegensatz dazu ist der korrigierte Strom $\underline{I}_{aQk}$ für $\alpha = 1$ mit dem Strom $\underline{I}_{bQ}$ des Parallelsystems identisch. Daher kann im Falle einer parallelen Doppelleitung alleine mit den Stromwerten das gestörte System genau identifiziert werden.

Das vorstehend beschriebene Korrekturverfahren (Gleichung 26) gestattet es, den fehlerbehafteten Stromkreis einer parallelbetriebenen Doppelleitung durch einen Stromvergleich eindeutig zu identifizieren und besitzt daher einen eigenständigen erfinderischen Gehalt.

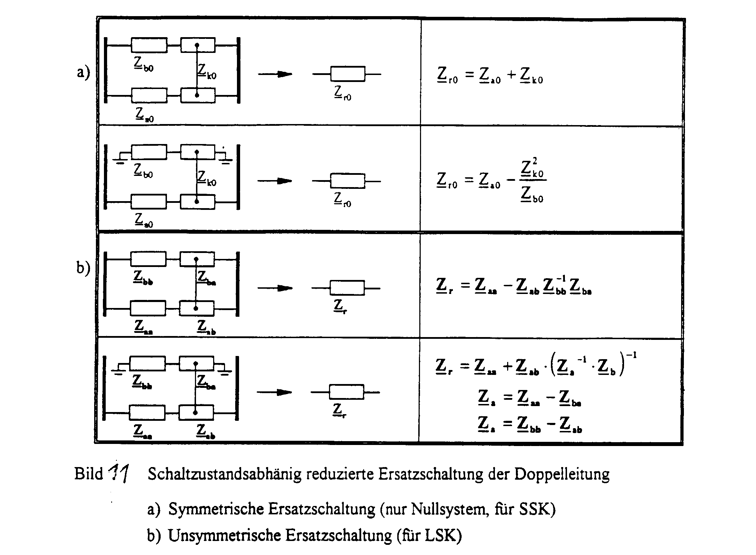

Die wechselseitige Übertragung und Analyse der Leiterströme kann mittels Stromkompensationsfaktoren vermieden werden, die vom Schaltzustand des Parallelsystems abhängen. Im Fall eines Kurzschlusses am Leitungsende ($\alpha = 1$), kann eine reduzierte Ersatzschaltung angegeben werden, die nur vom Schaltzustand der Doppelleiter abhängt. Bild 11 zeigt entsprechende Ersatzschaltbilder, und zwar in Bild 11a die symmetrische Ersatzschaltung die der Summenstromkompensationsmethode zugrunde liegt, und in Bild 11b eine Ersatzschaltung für unsymmetrische Leitungen, die der Leiterstromkompensationsmethode zugrunde liegt.

Die Stromkompensation kann auf diese Weise wie im Fall einer Einfachleitung durchgeführt werden. Wenn die Fehlerstelle sich irgendwo auf der Leitung befindet, ist dieses Modell inkorrekt, aber die berechnete Impedanz bewirkt immer eine selektive Auslösung. Die Vorteile dieses Verfahrens sind:

- keine Vorausbestimmung des fehlerbehafteten Systems,
- gleiche Anzahl von Eingangsströmen wie im Fall eines Schutzes für eine Einfachleitung und
- reduzierter Aufwand gegenüber der bedingten Stromkompensationstechnik.

Die Erfindung wird im folgenden anhand von in in Bildern dargestellten Ausführungsbeispielen näher beschrieben, aus denen sich weitere Einzelheiten, Merkmale und Vorteile ergeben.

Es zeigen:

Bild 1    eine schematische Darstellung der einen Drehstromleitung

Bild 2    eine der Berechnung der Kurzschlußimpedanzen der symmetrischen Drehstromleitung zugrunde liegende Anordnung:

    a) Modell
    b) Ersatzschaltung für Erdkurzschluß R-E im Bildraum der symmetrischen Komponenten

Bild 3    Ortskurven der Meßimpedanzen der Erdkurzschlußschleife R-E für verschiedene Netzerdungsverhältnisse und Impedanzberechnungsverfahren

    a-c) Impedanzberechnung ohne Stromkompensation

        a) Erdung nur im Vornetz
        b) Erdung nur in Vor- und Nachnetz
        c) Erdung nur im Nachnetz

    d) Impedanzberechnung mit Summenstromkompensation, Impedanzen für alle Erdungsverhältnisse gleich

Bild 4    eine physikalische Ersatzschaltung der Drehstromleitung mit einem Erdseil

Bild 5    eine reduzierte Ersatzschaltung der Drehstromleitung

Bild 6    ein Netzersatzschaltbild in Originalgrößen zur Berechnung der Kurzschlußimpedanzen der unsymmetrischen Leitung

Bild 7    Ersatzschaltungen der Doppelleitung

> a) Modell
> b) Unsymmetrische Leitung im Original raum
> c) Symmetrische Leitung im Bildraum der symmetrischen Komponenten

Bild 8    Ortskurven der Kurzschlußimpedanz der parallelbetriebenen, symmetrischen Doppelleitung

> a) Modell der Doppelleitung
> b) SSK (a&b)r: Impedanzen bei Summenstromkompensation mit beiden Summenströmen
> c) SSK ar: Impedanzen bei Summenstromkompensation nur mit dem Summenstrom des jeweiligen Systems

Bild 9    einen lokalen Stromvergleich bei parallel betriebener, symmetrischer Doppelleitung

> a) Modell
> b) Strombeträge gemessen am Leitungsanfang in Abhängigkeit vom Fehlerort
> c) Strombeträge gemessen am Leitungsende in Abhängigkeit vom Fehlerort

Bild 10    einen Ortskurvenstromkorrektur bei parallelbetriebener, mastunsymmetrischer Doppelleitung

> a) Ortskurven der Ströme am Leitungsanfang ohne Korrektur
> b) Ortskurven der Ströme am Leitungsanfang mit Korrektur

Bild 11    eine schaltzustandsbhängig reduzierte Ersatzschaltung der Doppelleitung

> a) Symmetrische Ersatzschaltung (nur Nullsystem, für SSK)
> b) Unsymmetrische Ersatzschaltung (für LSK)

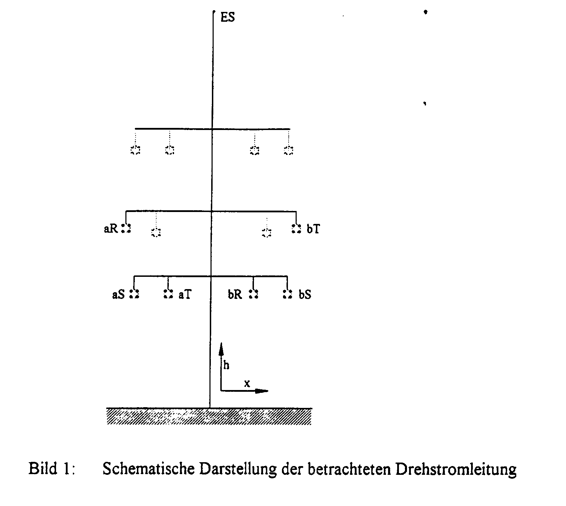

Bild 1 zeigt schematisch einen Mast mit vier Drehstromleitungen: 2 × 220 kV, 2 × 380 kV. In der weiteren Beschreibung der Erfindung werden nur die mit aR, aS, aT und bR, bS, bT bezeichneten Drehstromleitungen berücksichtigt. Für die beiden Leitungen werden folgende Höhen über der Erde und Abstände zum Mast angenommen:

| | Höhe h/m | Abstand zum Mast x/m |
|---|---|---|
| ES | 63,80 | 0,00 |
| a.R | 23,80 | -10,00 |
| a.S | 23,80 | -16,50 |
| a.T | 34,30 | -19,00 |
| b.R | 34,30 | 19,00 |
| b.S | 23,80 | 16,50 |
| b.T | 23,80 | 10,00 |

Es liegen Aluminiumbündelleiter vor: 4 × Al/St 340/40 mit a = 0,4. Die Einzelseile besitzen einen Widerstand R'= 0,0851 $\Omega$/km und einen Radius r = 0,025 cm.

Für das Erdseil wird angenommen:

ASLH - D9Ybb Ayl83/Aw66, wobei sich ein Widerstand R' = 0,1573 $\Omega$/km und ein Radius r = 0,011m ergibt.

Die Leitungslänge beträgt 21,6 km.

Für diese in Bild 1 dargestellte Doppelleitung ergeben sich nach Gleichungen (7 - 13) und Gleichung (22) folgende Impedanzmatrizen in Originalkomponenten:

$$\underline{Z}_{aa} = \begin{array}{|c|c|c|} \hline (1.2790 +j\ 10.5009) & (0.8194 +j\ 5.8179) & (0.8195 +j\ 4.7369) \\ \hline (0.8194 +j\ 5.8179) & (1.2790 +j\ 10.5186) & (0.8194 -j\ 5.0825) \\ \hline (0.8195 +j\ 4.7369) & (0.8194 -j\ 5.0825) & (1.2798 +j\ 10.4035) \\ \hline \end{array}\ \Omega$$

$$\underline{Z}_{ab} = \begin{array}{|c|c|c|} \hline (0.8195 +j\ 3.6483) & (0.8194 +j\ 3.9106) & (0.8195 +j\ 4.2837) \\ \hline (0.8194 +j\ 3.4098) & (0.8194 +j\ 3.6217) & (0.8194 +j\ 3.9106) \\ \hline (0.8203 +j\ 3.3152) & (0.8194 +j\ 3.4098) & (0.8195 +j\ 3.6483) \\ \hline \end{array}\ \Omega = \underline{Z}_{ba}^{T}$$

$$\underline{Z}_{bb} = \begin{array}{|c|c|c|} \hline (1.2798 +j\ 10.4035) & (0.8194 +j\ 5.0825) & (0.8195 +j\ 4.7369) \\ \hline (0.8194 +j\ 5.0825) & (1.2790 +j\ 10.5186) & (0.8194 +j\ 5.8179) \\ \hline (0.8195 +j\ 4.7369) & (0.8194 +j\ 5.8179) & (1.2790 +j\ 10.5009) \\ \hline \end{array}\ \Omega$$

Die Leitungsimpedanzmatrizen im Bildraum der symmetrischen Komponenten werden durch Transformation der 3 × 3-Submatrizen bestimmt, obwohl die Voraussetzung - Leitungssymmetrie - nicht gegeben ist.

$$\underline{Z}_{120} = \underline{T} \cdot \underline{Z}_{RST} \cdot \underline{T}^{-1}$$

$$\underline{T} = \begin{bmatrix} 1 & \underline{a} & \underline{a}^2 \\ 1 & \underline{a}^2 & \underline{a} \\ 1 & 1 & 1 \end{bmatrix}; \quad \underline{a} = e^{j\,120°}$$

Damit ergeben sich folgende diagonaldominanten Impedanzmatrizen im Bildraum der symmetrischen Komponenten:

$$\underline{Z}_{aa} = \begin{array}{|c|c|c|} \hline (0.4598 +j\ 5.2619) & (-0.5911 -j\ 0.1165) & (-0.3454 +j\ 0.0780) \\ \hline (0.5908 -j\ 0.1168) & (0.4598 +j\ 5.2619) & (0.3452 +j\ 0.0785) \\ \hline (0.3452 +j\ 0.0785) & (-0.3454 +j\ 0.0780) & (2.9182 +j\ 20.8992) \\ \hline \end{array} \ \Omega$$

$$\underline{Z}_{ab} = \begin{array}{|c|c|c|} \hline (0.0095 -j\ 0.0675) & (0.0726 -j\ 0.0422) & (-0.1643 +j\ 0.3947) \\ \hline (-0.0729 -j\ 0.0418) & (-0.0097 -j\ 0.0669) & (0.1641 +j\ 0.3953) \\ \hline (-0.2597 -j\ 0.3397) & (0.2603 -j\ 0.3398) & (2.4587 +j\ 11.0527) \\ \hline \end{array} \ \Omega$$

$$\underline{Z}_{ba} = \begin{array}{|c|c|c|} \hline (-0.0097 -j\ 0.0669) & (0.0726 -j\ 0.0422) & (0.2603 -j\ 0.3398) \\ \hline (-0.0729 -j\ 0.0418) & (0.0095 -j\ 0.0675) & (-0.2597 -j\ 0.3397) \\ \hline (0.1641 +j\ 0.3953) & (-0.1643 +j\ 0.3947) & (2.4587 +j\ 11.0527) \\ \hline \end{array} \ \Omega$$

$$\underline{Z}_{bb} = \begin{array}{|c|c|c|} \hline (0.4598 +j\ 5.2619) & (-0.1942 +j\ 0.5700) & (-0.1046 -j\ 0.3382) \\ \hline (0.1947 +j\ 0.5702) & (0.4598 +j\ 5.2619) & (0.1051 -j\ 0.3381) \\ \hline (0.1051 -j\ 0.3381) & (-0.1046 -j\ 0.3382) & (2.9182 +j\ 20.8992) \\ \hline \end{array} \ \Omega$$

Für das in Bild 7c dargestellte Ersatzschaltbild, in dem die Impedanzen der symmetrischen Komponenten eingezeichnet sind, gilt:

$$\underline{Z}_{a1} = (0.4598 +j\ 5.2619)\ \Omega$$

$$\underline{Z}_{a0} = (2.9182 +j\ 20.8992)\ \Omega$$

$$\underline{Z}_{k0} = (2.4587 +j\ 11.0527)\ \Omega$$

Diese Impedanzwerte erhält man auch bei einer Berechnung mit mittleren Abständen. Die Vernachlässigung der Nicht-Diagonalelemente führt zu einer symmetrischen Näherung der unsymmetrischen Leitung.

Die Mitimpedanz ($\underline{Z}_1$) und die Gegenimpedanz ($\underline{Z}_2$) sind gleich, da die Leitung eine ruhende Anordnung ist. Die Impedanzen beider Leitungssysteme (a & b) sind gleich, da die Leitungskonfiguration symmetrisch zum Mast ist.

Aus den obenstehenden Ersatzimpedanzen ergeben sich die folgenden Summenstromfaktoren:

$$\underline{k}_{aE} = (0.9966 -j\ 0.0686) = 0.9990\ e^{-j3.94°}$$

$$\underline{k}_{kE} = (0.7084 -j\ 0.0939) = 0.7146\ e^{-j7.55°}$$

Im folgenden wird zunächst der Fall einer Einfachleitung betrachtet. Dem entspricht der Schaltzustand "System b offen" der Doppelleitung. Die unsymmetrische Einfachleitung wird daher durch die Impedanzmatrix $\underline{Z}_{aa}$ beschrieben.

Bild 2a zeigt schematisch eine symmetrische Leitung L zwischen zwei Quellen Q, N an den beiden Leitungsenden. Es sei angenommen, daß auf der Leitung L ein Erdkurzschluß aufgetreten ist. Das Ersatzschaltbild der Anordnung ist in Bild 2b dargestellt, in der die Spannungen, Ströme und Impedanzen der symmetrischen Komponenten eingezeichnet sind. Die Indizes 1, 2, 0 bezeichnen jeweils die Größen des Mit-, Gegen- und Nullsystems; mit $\underline{U}_Q$ und $\underline{U}_N$ sind die beiden Quellenspannungen, mit $\underline{I}$ die Ströme, mit $\underline{Z}$ die Impedanzen und mit R die Widerstände bezeichnet. $\underline{I}_F$ bezeichnet den Fehlerstrom. $\alpha$ gibt die relative Entfernung des Fehlerorts von der Quelle Q an.

Bild 3 zeigt die Ortskurven der Impedanzen für Erdkurzschlüsse der Phase R bei unterschiedlichen Erdungswiderständen, wobei eine Erdung jeweils nur an einer Quelle oder an beiden Quellen vorgesehen ist.

Die in den Bildern 3a - 3c dargestellten Ortskurven der Impedanzen wurden ohne Stromkompensation (Gleichung 1) für $\alpha = 0..1$ bestimmt. Die Ortskurve gemäß Bild 3d wurde mit der oben beschriebenen Summenstromkompensation (Gleichung 2) bestimmt.

Anhand der Bilder 4 und 5 wurde die Berechnung der Leitungsimpedanzmatrix beschrieben. Anhand der Ersatzschaltung nach Bild 6 können schließlich die Impedanzen für alle Querfehlerarten auf der Leitung L berechnet werden. Dies wurde für die drei Kompensationsverfahren:

SSK: Summenstromkompensation mit komplexem $k_E$-Faktor
LSKr: Leiterstromkompensation mit reeller K-Matrix
GSK: Gemischte Stromkompensation mit reeller Symmetriermatrix Ka und komplexem $k_E$-Faktor

durchgeführt. Die Reaktanzfehler, d. h. die prozentuale Differenz zwischen Meß- und Leitungsmitreaktanz sind in nachstehender Tabelle 1 zusammengestellt.

Angenommen wurde ein Kurzschluß am Leitungsende ($\alpha = 1$, $R_F = O$), um die maximalen Reaktanzfehler angeben zu können. Der erste Wert ergibt sich jeweils bei beidseitiger Netzerdung ($\underline{Z}_{QO} = \underline{Z}_{NO}$). In Klammern sind zusätzlich die Werte für extreme Erdungsbedingungen angegeben [Erdung nur im Vornetz: $\underline{Z}_{NO} \to \infty$ ... Erdung nur im Nachnetz: $\underline{Z}_{QO} \to \infty$].

Tabelle 1:

| Relative Reaktanzfehler $\Delta x$ (%) bei Kurzschluß am Leitungsende für verschiedene Stromkompensationsverfahren und Netzerdungsverhältnisse. (Werte: N21 [N20 ... N22], vergl. Tabelle 4) Fettgedruckt sind jeweils die auswertbaren Schleifen mit kleinstem Fehler. Abkürzungen: SSK: Summenstromkompensation mit komplexem $k_E$-Faktor LSKr: Leiterstromkompensation mit reeller K-Matrix GSK: Gemischte Stromkompensation mit reeller Symmetriermatrix $\Delta$Ka und komplexem $k_E$-Faktor | | | | |
|---|---|---|---|---|
| Fehlerart | | SSK | LSKr | GSK |
| 1pE-R | RE | -0,4 [ 0,2 ... -1,8] | -0,2 [-0,4 ... -0,0] | 0,0 |
| 1pE-S | SE | -0,2 [ 1,7 ... -4,1] | -0,2 [-0,4 ... -0,0] | 0,0 |
| 1pE-T | TE | -0,5 [-2,4 ... 4,2] | -0,2 [-0,4 ... 0,0] | 0,0 |
| 2pE-RS | RS | -10,9 | -0,1 [-0,1 ... -0,0] | -0,1 [ 0,1 ... -0,0] |
| | RE | -7,8 [-8,3 ... -11,4] | -1,4 [-1,8 ... 0,2] | 0,6 [ 0,5 ... 0,2] |
| | SE | -7,1 [-7,3 ... -10,2] | 1,3 [ 1,6... -0,2] | -0.7 [-0,6 ... -0,3] |
| 2pE-ST | ST | 1,4 [ 1,4 ... 1,5] | 0,0 [ 0,1 ... -0,1] | 0,0 [ 0,1 ... -0,1] |
| | SE | 1,4 [ 2,2 ... 2,2] | -2,3 [-2,4 ... -0,1] | -0,1 [-0,0 ... -0,1] |
| | TE | 0,1 [-0,4 ... 0,7] | 1,9 [ 2,2 ... -0,1] | 0,1 [ 0,1 ... -0,1] |
| 2pE-TR | TR | 8,2 [ 8,2 ... 8,3] | 0,1 [-0,0 ... 0,1] | 0,1 [-0,0 ... 0,1] |
| | TE | 4,2 [ 4,3 ... 8,0]] | -2,4 [-1,6 ... -0,0] | -0,4 [-0,4 ... -0,0] |
| | RE | 4,9 [ 6,0 ... 8,3] | 2,6 [ 2,7 ... 0,3] | 0,5 [ 0,4 ... 0,3] |
| 2p-RS | RS | -10,9 | -0,1 | -0,1 |
| 2p-ST | ST | 1,4 | 0,0 | 0,0 |
| 2p-TR | TR | 8,2 | 0,1 | 0,1 |

Tabelle 1:   (fortgesetzt)

| Fehlerart | | SSK | LSKr | GSK |
|---|---|---|---|---|
| 3pE | RE | -4,5 [ 4,5 ... -3,6] | 1,8 [ 1,8 ... 1,6] | 1,6 |
| | SE | -5,3 [ -5,3 ... -4,7] | -1,2 [-1,2 ... -1,0] | -1,0 |
| | TE | 3.5 [ 3,5 ... 4,0] | -0,6 [-0,6 ... 0,5] | 0,5 |
| | RS | -11,1 | 0,3 | 0,3 |
| | ST | 0,2 [ 0,2 ... 0,4 ] | -0,9 | 0,9 |
| | TR | 7,7 [ 7,7 ... 7,8] | 0,7 | 0,7 |
| 3p | RS | -11,1 [-11,0 ... -11,0] | 0,3 | 0,3 |
| | ST | 0,2 [ 0,4 ... 0,4] | -0,9 | -0,9 |
| | TR | 7,7 [ 7,8 ... 7,8] | 0,7 | 0,7 |

Die Anwendung der Summenstromkompensation (SSK) liefert die mit Abstand größten Auswertefehler, da ihr ein entsprechend ungenaues Leitungsmodell zugrunde liegt. Insbesondere auf die großen Reaktanzfehler der Leiter-Leiter-Schleifen nimmt die Summenstromkompensation verfahrensbedingt keinen Einfluß, da in diesen Schleifen die Impedanz aus Spannungs- und Stromdifferenzen berechnet wird.

Die exakte, komplexe Leiterstromkompensation ist fehlerfrei und daher in der Tabelle nicht aufgeführt. Die Näherung mit reellwertiger Kompensationsmatrix (LSKr) führt zu kleinen Reaktanzfehlern. Gegenüber der Summenstromkompensation sind die Verbesserungen insbesondere in den Leiter-Leiter-Schleifen beachtlich.

Die gemischte Stromkompensation (GSK) mit reeller Korrekturmatrix ist in den Leiter-Erd-Schleifen praktisch exakt, liefert also auch gegenüber der Leiterstromkompensation mit reellen Faktoren ein besseres Ergebnis. Dies ist dadurch möglich, daß der signifikante Unterschied zwischen Null- und Mitimpedanz durch $\underline{k}_E$ exakt erfaßt wird.

Die Netzeinspeisebedingungen haben auf diese Ergebnisse keinen signifikanten Einfluß. Es wurde angenommen, daß die Quellenspannungen gleich und symmetrisch sind.

$$\underline{U}_Q = \underline{U}_N = \frac{220\ kV}{\sqrt{3}}\ kV$$

Die Quellenimpedanzen wurden gemäß der im Buch "Elektrische Energieversorgung" von Heuck, K. und Dettmann, K.-D., Vieweg Verlag, Braunschweig, 1984, angegebenen Methode wie folgt berechnet:

$$Z_Q = \frac{1.1 \cdot U_n^2}{S''_k} = \frac{1.1 \cdot (220\ kV)^2}{25\ GVA} = 2,13\ \Omega$$

$$\frac{R_Q}{X_Q} = 0,1$$

$$\Rightarrow \underline{Z}_{Q1} = \underline{Z}_{N1} = \underline{Z} = (0,2 + j2.0)\Omega$$

$$\frac{\underline{Z}_{Q0}}{\underline{Z}_{Q1}} = \frac{\underline{Z}_{N0}}{\underline{Z}_{N1}} = 3$$

Im folgenden wird die Anwendung des Impedanzberechnungsverfahrens bei Doppelleitungen gezeigt. Hierzu sind in Bild 7a das Modell, in Bild 7b die Ersatzschaltung in Matrizendarstellung und in Bild 7c die Ersatzschaltung der symmetrischen Doppelleitung in 120-Komponenten dargestellt. Anhand Bild 8 wurde die Notwendigkeit der "bedingten" Stromkompensation bereits erläutert. Die Ergebnisse verschiedener Kompensationsverfahren sind in der folgenden Tabelle 2 zusammengestellt. Dabei wurden die gleichen Netzverhältnisse wie zuvor bei der Einfachleitung angenommen, allerdings sind nur die Werte bei gleichmäßiger Erdung in Vor- und Nachnetz dargestellt. Kurzschlußbehaftet sei System a der parallelgeschalteten Doppelleitung ($\alpha = 1$, $R_F = 0$). Berechnet wurden die Impedanzen für DSEaQ (vgl. Bild 8a).

Tabelle 2:

| Relative Reaktanzfehler $\Delta x$ (%) bei Kurzschluß am Doppelleitungsende für verschiedene Stromkompensationsverfahren . (Netzerdung N21 nach Tabelle 4) Fettgedruckt sind jeweils die auswertbaren Schleifen mit kleinstem Fehler. Abkurzungen: | | | | | | |
|---|---|---|---|---|---|---|
| Einstellung auf Einfachleitung : | | | | | | |
| SSKa: Summenstromkempensation mit komplexem $\underline{k}_E$-Faktor | | | | | | |
| LSKar: Leiterstromkompensation mit reeller K-Matrix | | | | | | |
| GSKa: Gemischte Stromkompensation mit reeller Symmetriermatrix $\Delta$Ka und komplexem $\underline{k}_E$-Faktor | | | | | | |
| Einstellung auf Doppelleitung: | | | | | | |
| SSK(a&b): Summenstromkompensation mit komplexen $\underline{k}_E$- und $\underline{k}_{EK}$-Faktoren | | | | | | |
| GSKa & SSKb: Gemischte Stromkompensation mit reeller Symmetriermatrix $\Delta$Ka und komplexen $\underline{k}_E$- und $\underline{k}_{EK}$-Faktoren | | | | | | |
| SSK(a&b)r: Leiterstromkompensation mit reellen K-Matrizen | | | | | | |
| Fehlerart | | SSKa | LSKar | GSKa | SSK (a&b) | GSKa & SSKb | LSK (a&b)r |
| IpE-R | RE | 26,6 | 27,1 | 27,4 | -1,7 | -1,2 | -0,4 |
| IpE-S | SE | 28,7 | 29,4 | 29,8 | -1,5 | -0,9 | -0.4 |
| IpE-T | TE | 34,1 | 33,5 | 33,9 | 0,2 | 0,1 | -0,4 |
| 2pE-RS | RS | -11,3 | -0,5 | -0,3 | -11,3 | -0,5 | -0,0 |
| | RE | -9,1 | -1,3 | 0,6 | -9,7 | -2,4 | -2,8 |
| | SE | 6,0 | 18,5 | 16,1 | -5,4 | 0,7 | 2,9 |
| 2pE-ST | ST | 1,1 | -0,6 | -0,6 | 1,1 | -0,6 | 0,0 |
| | SE | -0,1 | -3,9 | -2,1 | -2,6 | -3,9 | -3,5 |
| | TE | 21,1 | 22,7 | 20,3 | 3,3 | 2,8 | 3,6 |
| 2pE-TR | TR | 4,9 | -1,0 | -3,0 | 4,9 | -3,0 | -0,1 |
| | TE | 24,1 | 13,5 | 15,9 | 7,4 | 2,8 | -4,0 |
| | RE | 3,3 | -0,7 | -2,3 | -3,1 | -6,7 | 3,3 |
| 2p-RS | RS | -11,3 | -0,6 | -0,6 | -11,3 | -0,6 | -0,1 |
| 2p-ST | ST | 1,0 | -0,6 | -0,6 | 1,0 | -0,6 | 0,0 |
| 2p-TR | TR | 5,0 | -2,9 | -1,9 | 5,0 | -2,9 | 0,0 |
| 3pE | RE | -12,0 | -9,8 | -9,7 | -10,1 | -6,8 | 1,1 |
| | SE | -7,4 | -5,1 | -5,5 | -6,1 | -3,2 | -0,6 |
| | TE | 15,6 | 10,0 | 10,3 | 10,2 | 5,1 | -0,6 |
| | RS | -11,3 | -0,3 | -0,3 | -11,3 | -0,3 | 0,1 |
| | ST | -0,1 | -1,7 | -1,7 | -0,1 | -1,7 | -0,9 |
| | TR | 4,4 | -2,3 | -2,3 | 4,4 | -2,3 | 0,6 |
| 3p | RS | -11,3 | -0,3 | -0,3 | -11,3 | -0,3 | 0,1 |
| | ST | -0,0 | -1,7 | -1,7 | -0,0 | -1,7 | -0,9 |
| | TR | 4,4 | -2,3 | -2,3 | 4,4 | -2,3 | 0,7 |

In drei Fällen wurde eine Einstellung der Distanzschutzeinrichtung DSEaQ auf die Einfachleitung "System a" angenommen.

SSKa: Summenstromkompensation mit komplexem $\underline{k}_E$-Faktor

LSKar: Leiterstromkompensation mit reeller K-Matrix

GSKa: Gemischte Stromkompensation mit reeller Symmetriermatrix $\Delta$ Ka und komplexem $\underline{k}_E$-Faktor

Alle drei Verfahren zeigen unbefriedigende Ergebnisse bei Leiter-Erde-Kurzschlüssen, was auf die unberücksichtigte Systemkopplung im Nullsystem zurückzuführen ist.

Bei einer Schutzeinstellung auf Doppelleitung wurden folgende Varianten untersucht:

SSK(a&b): Summenstromkompensation mit komplexen $\underline{k}_E$- und $\underline{k}_{EK}$-Faktoren

GSKa & SSKb: Gemischte Stromkompensation mit reeller Symmetriermatrix $\Delta$ Ka und komplexen $\underline{k}_E$- und $\underline{k}_{EK}$-Faktoren

SSK(a&b)r: Leiterstromkompensation mit reellen K-Matrizen

Durch die Hinzunahme des Summenstroms des gesunden Parallelsystems werden die Reaktanzfehler der Leiter-Erde-Schleifen deutlich verkleinert. Bei der bedingten Summenstromkompensation verbleiben allerdings große Reaktanzfehler in den Leiter-Leiter-Schleifen. Bei gleicher Anzahl von nur 4 Stromeingängen liefert demgegenüber die Kombination mit dem erfindungsgemäßen Verfahren (GSKa & SSKb) in allen Schleifen hinreichend gute Ergebnisse. Die bedingte Leiterstromkompensation LSK(a&b)r ist zwar besser, benötigt aber alle 6 Leiterströme, was einen nicht immer zu realisierenden Mehraufwand bedeutet.

Wie bereits ausgeführt wurde, setzen die "bedingten" Stromkompensationsverfahren die Kenntnis des fehlerbehafteten Stromkreises voraus. Diese Entscheidung ist nur bei Parallelschaltung der Doppelleitungssysteme relevant und kann, wie anhand der Bilder 9 und 10 bereits gezeigt wurde, durch einen Stromvergleich getroffen werden.

Als Alternative bietet sich eine schaltzustandsabhängige Schutzparametrierung entsprechend Bild 11 an. Dies wurde für die beiden Schaltzustände "System a parallelgeschaltet" und "System b geerdet" untersucht. Untenstehende Tabelle 3 zeigt die ermittelten Reaktanzfehler. Es wurden wiederum Kurzschluß am Ende von Leitung a und gleiche Netze auf beiden Seiten angenommen. Die Impedanzberechnung erfolgte mit den drei, für die Einfachleitung beschriebenen Stromkompensationsverfahren. Wie dort, zeigte das erfindungsgemäße Verfahren (GSK) die kleinsten Reaktanzfehler.

Die Verwendung schaltzustandsabhängiger Modelle zur Schutzparametrierung ist von besonderem Vorteil, da keine Strommeßgrößen vom Parallelsystem zur Schutzeinrichtung übertragen werden müssen. Damit reduzieren sich der Verdrahtungsaufwand und die Störanfälligkeit des Schutzsystems. Außerdem wird nur eine kleinere Rechenleistung für die Impedanzberechnung benötigt.

Tabelle 3:

| Relative Reaktanzfehler $\Delta$x (%) bei Kurzschluß am Doppelleitungsende für verschiedene Stromkompensationsverfahren mit schaltzustandsabhängigen Parametern. (Netzerdung N21 nach Tabelle 4) Fettgedruckt sind jeweils die auswenbaren Schleifen mit kleinstem Fehler. | | | | | | | |
|---|---|---|---|---|---|---|---|
| Abkürzangen :<br>SSK: Summenstromkompensation mit komplexem $\underline{k}_E$-Faktor<br>LSKr: Leiterstromkompensation mit reeller K-Matrix<br>GSK: Gemischte Stromkompensation mit reeller Symmetriermatrix $\Delta$Ka und komplexem $\underline{k}_E$-Faktor | | | | | | | |
| | | System b parallelgeschalter | | | System b geerdet | | |
| Fehlerart | | SSK | LSKr | GSK | SSK | LSkr | GSK |
| 1pE-R | RE | -2,9 | -0,4 | 0,0 | -3,7 | 0,1 | -0,0 |
| 1pE-S | SE | -0,4 | -0,4 | -0,0 | 0,9 | 0,1 | 0,0 |
| 1pE-T | TE | 4,0 | -0,4 | 0,0 | 1,7 | 0,1 | -0,0 |
| 2pE-RS | RS | -9,8 | -0,0 | -0,0 | -10,9 | -0,1 | -0,1 |
| | RE | -11,9 | -2,8 | 0,5 | -11,0 | 1,1 | 0,6 |
| | SE | -1,7 | 3,1 | -0,7 | -5,0 | -1,1 | -0,7 |
| 2pE-ST | ST | 2,7 | 0,0 | 0,0 | 1,6 | 0,0 | 0,0 |
| | SE | -4,5 | -3,3 | -0,1 | 0,7 | 0,4 | -0,1 |
| | TE | 8,5 | 3,8 | 0,2 | 2,1 | -0,3 | 0,1 |

Tabelle 3: (fortgesetzt)

| Fehlerart | | System b parallelgeschalter | | | System b geerdet | | |
|---|---|---|---|---|---|---|---|
| | | SSK | LSKr | GSK | SSK | LSkr | GSK |
| 3pE-TR | TR | 6,6 | -0,1 | -0,1 | 8,0 | 0,1 | 0,1 |
| | TE | 16,9 | -4,3 | -0,4 | 8,7 | 0,1 | -0,4 |
| | RE | -7,4 | 3,0 | 0,2 | 0,6 | 0,0 | 0,5 |
| 2p-RS | RS | -9,8 | -0,1 | -0,1 | -10,9 | -0,1 | -0,1 |
| 2pST | ST | 2,7 | 0,0 | 0,0 | 1,5 | 0,0 | 0,0 |
| 2p-TR | TR | 6,7 | 0,0 | 0,0 | 8,1 | 0,1 | 0,1 |
| 3pE | RE | -13,5 | 0,7 | 1,0 | -7,8 | 1,5 | 1,5 |
| | SE | -6,0 | -0,0 | -1,1 | -4,2 | -1,0 | -1,0 |
| | TE | 22,3 | -0,8 | -0,0 | 7,0 | -0,4 | -0,5 |
| | RS | -9,9 | 0,1 | 0,1 | -11,1 | 0,2 | 0,2 |
| | ST | 1,6 | -0,9 | -0,9 | 0,4 | -0,9 | -0,9 |
| | TR | 6,1 | 0,6 | 0,6 | 7,6 | 0,7 | 0,7 |
| 3p | RS | -9,9 | 0,1 | 0,1 | -11,1 | 0,2 | 0,2 |
| | ST | 1,6 | -0,9 | -0,9 | 0,4 | -0,9 | -0,9 |
| | TR | 6,1 | 0,6 | 0.6 | 7,6 | 0,7 | 0,7 |

In einer Distanzschutzeinrichtung werden die auf die oben beschriebene Weise bestimmten Impedanzen mit voreingestellten Werten von Impedanzzonen verglichen. Beispielsweise sind in der Distanzschutzeinrichtung vier Impedanzzonen einstellbar. Aus der jeweiligen Fehlerimpedanz wird durch Multiplikation mit dem Cosinus bzw. Sinus des für die Distanzmessung von der Distanzschutzeinrichtung ausgewählten Winkels die Fehlerresistanz und die Fehlerreaktanz berechnet. Diese berechneten Größen werden mit Referenzgrößen der Impedanzzonen verglichen. Liegen diese Größen innerhalb eines oder mehrerer eingestellter Distanzzonen, erfolgt ein Distanzentscheid der entsprechenden Zone. Für die Impedanzzonen stehen auch noch Zeitstufen zur Verfügung, die für die Impedanz-Zeit-Staffelung bestimmt sind. Auf "Distanz-Aus" wird entschieden, wenn ein Distanzentscheid der jeweiligen Zone vorliegt und die der Impedanzone zugeordnete Zeitstufe abgelaufen ist sowie die gemessene Richtung der mit dieser Impedanzzone zugeordneten Richtungseinstellung übereinstimmt. Bei "Distanz-Aus" wird der der Distanzschutzeinrichtung zugeordnete Leistungsschalter betätigt, der vor dem Abzweig der Hochspannungsleitung angeordnet ist.

**Patentansprüche**

1. Verfahren zur Erzeugung eines Impedanzwerts und zu dessen Verarbeitung in einer Distanzschutzeinrichtung, die unsymmetrische Energieübertragungsleitungen überwacht, wobei der Impedanzwert dem Abstand zwischen einem Fehlerort und einem Meßort proportional ist, an dem die Ströme und Spannungen der übertragungsleitungen gemessen werden,
   **dadurch gekennzeichnet,**
   daß eine Summenstromkompensationsmatrix $\underline{\mathbf{K}}_\Sigma$ mit Hilfe der Summenstromgleichung

$$\underline{I}_\Sigma = \underline{I} + \underline{k}_\varepsilon \underline{I}_\varepsilon \begin{pmatrix} 1 \\ 1 \\ 1 \end{pmatrix} = \underline{\mathbf{K}}_\Sigma \underline{I}$$

nach der Beziehung:

$$\underline{K}_\Sigma = E + \underline{k}_E F$$

mit

$$E = \begin{pmatrix} 1 & 0 & 0 \\ 0 & 1 & 0 \\ 0 & 0 & 1 \end{pmatrix}; \quad F = \begin{pmatrix} 1 & 1 & 1 \\ 1 & 1 & 1 \\ 1 & 1 & 1 \end{pmatrix}, \quad \underline{k}_E = \frac{\underline{Z}_0 - \underline{Z}_1}{3\,\underline{Z}_1}$$

gebildet wird, worin mit $\underline{I}_\Sigma$ der Summenstrom, mit $\underline{I}$ die gemessenen Leiterströme, mit $\underline{k}_E$ ein Korrekturfaktor, mit $\underline{Z}_0$ die Nullsystemimpedanz, mit $\underline{Z}_1$ die Mitsystemimpedanz bezeichnet sind, daß die Summenstromkompensationsmatrix $\underline{K}_\Sigma$ in eine genaue Phasenstromkompensationsmatrix $\underline{K}_P$ durch den Ersatz der Einheitsmatrix $\underline{E}$ mit einer komplexen, symmetrischen Korrekturmatrix $\Delta\underline{K}$ nach der folgenden Beziehung derart umgewandelt wird, daß die Summenstrom- und die Leiterstromkompensationsmatrizen gleich sind:

$$\underline{K}_P = \Delta\underline{K} + \underline{k}_E F$$

$$\Delta\underline{K} = K_P - \underline{k}_E F$$

worin mit $\underline{K}_P$ die Leiterstromkomdensationsmatrix bezeichnet ist, daß die Impedanz nach dem Summenstromverfahren wie folgt bestimmt wird:

$$\underline{I}_\Sigma = (\Delta\,\underline{K} + \underline{k}_E\, F) \cdot \underline{I}$$

und daß die Impedanz in der Distanzschutzeinrichtung mit gespeicherten Referenzgrößen verglichen wird, um in Abhängigkeit vom Vergleichsergebnis einen Leistungsschalter auszulösen oder nicht auszulösen, an den die Energieübertragungsleitungen angeschlossen sind.

2. Verfahren zur Erzeugung eines Impedanzwerts und zu dessen Verarbeitung in einer Distanzschutzeinrichtung nach Anspruch 1, die parallele, unsymmetrische Doppelleitungen überwacht, wobei der Impedanzwert dem Abstand zwischen einem Fehlerort und Meßorten proportional ist, an dem die Ströme und Spannungen der Doppelleitungen gemessen werden,
**dadurch gekennzeichnet,**
daß der Summenstrom einer parallelgeführten, nicht kurzschlußbehafteten Leitung bei der Impedanzberechnung wie folgt berücksichtigt wird:

$$\underline{I}_{\Sigma a} = (\underline{K} + \underline{k}_{Ea}\, F)\,\underline{I}_a + \underline{k}_{EK}\, F\,\underline{I}_b$$

wobei der Index a die Größen des kurzschlußbehafteten Systems und b die Größen des fehlerfreien Systems der Doppelleitung, $\underline{K}$ und $\underline{k}_{Ea}$ die Summenstromkompensationsgrößen des Verfahrens gemäß Anspruch 1,

$$\underline{K}_{EK} = \frac{\underline{Z}_{OK}}{3\underline{Z}_{1a}}$$

der Faktor zur Korrektur des Einflusses des Summenstroms des Systems b und $\underline{Z}_{OK}$ die Nullsystemkopplungsimpedanz der beiden Systems sind.

3. Verfahren nach Ansprüchen 1 und 2,
**dadurch gekennzeichnet,** daß die komplexe Korrekturmatrix $\Delta\underline{K}$ durch eine reelle Matrix $\Delta K$ nach der Beziehung:

$\Delta K = \text{Re } \{\underline{\Delta K}\}$ ersetzt wird.

4. Verfahren nach Anspruch 2 zur Bestimmung des kurzschlußbehafteten Systems einer unsymmetrischen Doppelleitung,
   **dadurch gekennzeichnet,**
   daß aus dem Größenvergleich der Leiterströme der beiden Leitungen die fehlerbehaftete Leitung durch den größeren Strom ermittelt wird, wobei die Unsymmetrie durch eine komplexe Korrektur des Leiterstroms $\underline{I}_a$ nach folgender Beziehung berücksichtigt wird:

$$\underline{I}_{aK} = \underline{K}_i \cdot \underline{I}_a = [\, (\underline{Z}_{aa} - \underline{Z}_{ba})^{-1} \cdot (\underline{Z}_{bb} - \underline{Z}_{ab})\,]\cdot \underline{I}_a$$

worin $\underline{Z}_{aa}, \underline{Z}_{ab}, \underline{Z}_{ba}, \underline{Z}_{bb}$ die komplexen $3 \times 3$-Untermatrizen der Leitungsimpedanzmatrix der Doppelleitung sind.

5. Verfahren nach Anspruch 1 zur Bestimmung einer dem Abstand zwischen einem Fehlerort und einem Meßort proportionalen Impedanz bei einer Distanzschutzeinrichtung, die eine Doppelleitung überwacht, wobei der Impedanzwert dem Abstand zwischen einem Fehlerort und Meßorten proportional ist, an denen die Ströme und Spannungen der Doppelleitung gemessen werden,
   **dadurch gekennzeichnet,**
   daß die Doppelleitung durch eine schaltzustandsabhängig reduzierte Ersatzschaltung nachgebildet wird und die Parameter des Summenstromkompensationsverfahrens wie bei einer Einfachleitung aus den Impedanzen dieser reduzierten Ersatzschaltung berechnet werden.

## Claims

1. A method of producing an impedance value and processing same in a distance protection device which monitors asymmetrical energy transmission lines, wherein the impedance value is proportional to the distance between a fault location and a measurement location at which the currents and voltages of the transmission lines are measured, characterised in that a sum current compensation matrix $\underline{K}_\Sigma$ is formed by means of the sum current equation

$$\underline{I}_\Sigma = \underline{I} + \underline{k}_\Sigma \underline{I}_\Sigma \begin{pmatrix} 1 \\ 1 \\ 1 \end{pmatrix} = \underline{K}_\Sigma \underline{I}$$

in accordance with the relationship:

$$\underline{K}_r = E + \underline{k}_E F$$

with

$$E = \begin{pmatrix} 1 & 0 & 0 \\ 0 & 1 & 0 \\ 0 & 0 & 1 \end{pmatrix}; \quad F = \begin{pmatrix} 1 & 1 & 1 \\ 1 & 1 & 1 \\ 1 & 1 & 1 \end{pmatrix}, \quad \underline{k}_\Sigma = \frac{\underline{z}_0 - \underline{z}_1}{3\,\underline{z}_1}$$

wherein $\underline{I}_\Sigma$ denotes the sum current, $\underline{I}$ denotes the measured conductor currents, $\underline{k}_E$ denotes a correction factor, $\underline{Z}_0$ denotes zero-sequence system impedance, and $\underline{Z}_1$ denotes positive-sequence system impedance, that the sum current compensation matrix $\underline{K}_\Sigma$ is converted into a precise phase current compensation matrix $\underline{K}_P$ by replacement of the unit matrix $\underline{E}$ by a complex symmetrical correction matrix $\underline{\Delta K}$ in accordance with the following relationship in such a way that the sum current and conductor current compensation matrices are identical:

$$\underline{K}_P = \Delta\underline{K} + \underline{k}_E F$$

$$\Delta\underline{K} = \underline{K}_P - \underline{k}_E F$$

wherein $\underline{K}_P$ denotes the conductor current compensation matrix, that the impedance is determined in accordance with the sum current process as follows:

$$\underline{I}_\Sigma = (\Delta\,\underline{k} + \underline{k}_E\,F)\cdot I$$

and that the impedance is compared in the distance protection device to stored reference values in order in dependence on the result of the comparison to trip or not trip a power switch to which the energy transmission lines are connected.

2. A method of producing an impedance value and processing thereof in a distance protection device according to claim 1 which monitors parallel asymmetrical double lines, wherein the impedance value is proportional to the distance between a fault location and a measurement location at which the currents and voltages of the double lines are measured, characterised in that
the sum current of a parallel-guided line which is not affected by a short circuit is taken into consideration in impedance calculation as follows:

$$\underline{I}_{\Sigma a} = (\,\underline{K} + \underline{k}_{Ea}\,F)\,\underline{I}a + \underline{k}_{EK}\,F\,\underline{I}_b$$

wherein the index a denotes the values of the system which is affected by a short circuit and b denotes the values of the fault-free system of the double line, $\underline{K}$ and $\underline{k}_{Ea}$ denote the sum current compensation values of the method according to claim 1,

$$\underline{k}_{EK} = \frac{\underline{Z}_{OK}}{3\underline{Z}_{1a}}$$

denotes the factor for correction of the influence of the sum current of the system b and $\underline{Z}_{OK}$ denotes the zero-sequence system coupling impedance of the two systems.

3. A method according to claim 1 and claim 2 characterised in that the complex correction matrix $\Delta\underline{K}$ is replaced by a real matrix $\Delta K$ in accordance with the relationship: $\Delta K = \text{Re}\{\Delta\,\underline{K}\}$.

4. A method according to claim 2 for determining the system affected by a short circuit of an asymmetrical double line characterised in that the fault-affected line is ascertained from the comparison of the magnitudes of the conductor currents of the two lines by virtue of the greater current, wherein the asymmetry is taken into account by a complex correction of the conductor current $\underline{I}_a$ in accordance with the following relationship:

$$\underline{I}_{aK} = \underline{K}_i \cdot \underline{I}_a = [\,(\underline{Z}_{aa} - \underline{Z}_{ba})^{-1} \cdot (\underline{Z}_{bb} - \underline{Z}_{ab})\,]\cdot\underline{I}_a$$

wherein $\underline{Z}_{aa}, \underline{Z}_{ab}, \underline{Z}_{ba}, \underline{Z}_{bb}$ are the complex 3 × 3-sub-matrices of the line impedance matrix of the double line.

5. A method according to claim 1 for determining an impedance proportional to the distance between a fault location and a measurement location in a distance protection device which monitors a double line wherein the impedance value is proportional to the distance between a fault location and measurement locations at which the currents and voltages of the double line are measured, characterised in that the double line is emulated by an equivalent circuit which is reduced in dependence on switching condition and the parameters of the sum current compensation method are calculated as in the case of a single line from the impedances of said reduced equivalent circuit.

**Revendications**

1. Procédé pour obtenir une valeur d'impédance et pour le traitement dans un dispositif de protection à distance, qui contrôle les lignes de transmission d'énergie asymétriques, où la valeur d'impédance est proportionnelle à la distance entre un lieu de défaut et un lieu de mesure, au niveau duquel les courants et tensions des lignes de transmission sont mesurés, caractérisé en ce qu'une matrice de compensation du courant de somme $\underline{K}\Sigma$ est constituée à partir de l'équation de courant de somme,

$$\underline{I}_{\underline{\Sigma}} = \underline{I} + \underline{k}_{\underline{\Sigma}}\,\underline{I}_{\underline{\Sigma}}\begin{pmatrix}1\\1\\1\end{pmatrix} = \underline{K}_{\underline{\Sigma}}\,\underline{I}$$

suivant la relation :

$$\underline{K}_r = E + \underline{k}_E F$$

avec

$$E = \begin{pmatrix}1 & 0 & 0\\0 & 1 & 0\\0 & 0 & 1\end{pmatrix};\quad F = \begin{pmatrix}1 & 1 & 1\\1 & 1 & 1\\1 & 1 & 1\end{pmatrix},\quad \underline{k}_{\underline{\Sigma}} = \frac{\underline{z}_0 - \underline{z}_1}{3\,\underline{z}_1}$$

où le courant de somme est appelé $\underline{I}\Sigma$, les courants de ligne mesurées $\underline{I}$ un facteur de correction $\underline{K}_E$, l'impédance du système zéro $\underline{Z}_o$, l'impédance du système direct $\underline{Z}_1$ et en ce que la matrice de compensation du courant de somme $\underline{K}_\Sigma$ est transformée en une matrice de compensation du courant de phase $\underline{K}p$ exacte par remplacement de la matrice unité $\underline{E}$ par une matrice de correction $\underline{\Delta K}$ complexe, symétrique, selon la relation suivante de manière que la matrice de compensation du courant de somme et la matrice de compensation du courant de ligne soient identiques:

$$\underline{K}_P = \Delta\,\underline{K} + \underline{k}_E F$$

$$\Delta\underline{K} = \underline{K}_P - \underline{k}_E F$$

où $\underline{K}p$ désigne la matrice de compensation du courant de ligne, en ce que l'impédance selon le procédé de courant de somme est déterminée comme suit :

$$\underline{I}_\Sigma = (\Delta\,\underline{K} + \underline{k}_E\,F)\cdot\underline{I}$$

et en ce que l'impédance est comparée à des grandeurs de référence enregistrées dans le dispositif de protection à distance pour déclencher ou ne pas déclencher, en fonction du résultat de la comparaison, un disjoncteur, auquel les lignes de transmission d'énergie sont raccordées.

2. Procédé pour obtenir une valeur d'impédance et pour le traitement dans un dispositif de protection à distance selon la revendication 1, qui contrôle les lignes doubles parallèles, asymétriques, où la valeur d'impédance est proportionnelle à la distance entre un lieu de défaut et des lieux de mesure,au niveau desquels les courants et tensions des lignes doubles sont mesurés,

caractérisé en ce que le courant de somme d'une ligne guidée de manière parallèle, sans court-circuit est considéré par le calcul d'impédance comme suit :

$$\underline{I}_{\Sigma a} = (\ \underline{K} + \underline{k}_{Ea}\ F)\ \underline{I}_a + \underline{k}_{EK}\ F\ \underline{I}_b$$

où l'indice a représente les grandeurs du système avec court-circuit et b les grandeurs du système sans défaut de la ligne double, $\underline{K}$ et $\underline{k}_{Ea}$ les grandeurs de compensation du courant de somme du procédé selon la revendication 1,

$$\underline{k}_{EK} = \frac{\underline{Z}_{OK}}{3\underline{Z}_{1a}}$$

le facteur pour la correction de l'influence du courant de somme du système b et $\underline{Z}$ok l'impédance de couplage du système zéro des deux systèmes.

3. Procédé selon les revendications 1 et 2, caractérisé en ce que la matrice de correction complexe $\underline{\Delta K}$ est substituée par une matrice réelle $\Delta$ K suivant la relation

4. Procédé selon la revendication 2 pour la détermination du système avec court-circuit d'une ligne double asymétrique caractérisé en ce que, à partir de la comparaison des grandeurs des courants de ligne des deux lignes, la ligne portant l'erreur est découverte par le courant le plus grand, où l'asymétrie est prise en considération par une correction complexe du courant de ligne la selon la relation suivante :

$$\underline{I}_{aK} = \underline{K}_i \cdot \underline{I}_a = [\ (\underline{Z}_{aa} - \underline{Z}_{ba})^{-1} \cdot (\underline{Z}_{bb} - \underline{Z}_{ab})\ ] \cdot \underline{I}_a$$

où $\underline{Z}$aa, $\underline{Z}$ab, $\underline{Z}$ba, $\underline{Z}$bb sont les sous-matrices 3x3 complexes de la matrice d'impédance de ligne de la ligne double.

5. Procédé selon la revendication 1 pour obtenir une impédance proportionnelle à la distance entre un lieu de défaut et un lieu de mesure, à partir d'un dispositif de protection à distance, qui contrôle une ligne double, où la valeur de l'impédance est proportionnelle à la distance entre un lieu de défaut et des lieux de mesure, au niveau desquels les courants et les tensions de la ligne double sont mesurés, caractérisé en ce que la ligne double est simulée par un couplage de compensation réduit dépendant de l'état de commutation et les paramètres du procédé de compensation du courant de somme sont calculés à partir des impédances de ce couplage réduit de compensation, comme pour une ligne simple.

Bild 1:    Schematische Darstellung der betrachteten Drehstromleitung

Bild 2:  Berechnung der Kurzschlußimpedanzen der symmetrischen Drehstromleitung

a) Modell

b) Ersatzschaltung für Erdkurzschluß R-E im Bildraum der symmetrischen
  Komponenten

Bild 3:    Meßimpedanzen der Erdkurzschlußschleife R-E für verschiedene
Netzerdungsverhältnisse und Impedanzberechnungsverfahren

a-c)    Impedanzberechnung ohne Stromkompensation
   a) Erdung nur im Vornetz
   b) Erdung nur in Vor- und Nachnetz
   c) Erdung nur im Nachnetz

d)    Impedanzberechnung mit Summenstromkompensation,
Impedanzen für alle Erdungsverhältnisse gleich

Bild 4:    Physikalische Ersatzschaltung der Drehstromleitung mit einem Erdseil

Bild 5:    Reduzierte Ersatzschaltung der Drehstromleitung

Bild 6: Netzersatzschaltbild in Originalgrößen zur Berechnung der Kurzschlußimpedanzen der unsymmetrischen Leitung

Bild 7: Ersatzschaltungen der Doppelleitung

a) Modell

b) Unsymmetrische Leitung im Originalraum

c) Symmetrische Leitung im Bildraum der symmetrischen Komponenten

Bild 8:    Kurzschlußimpedanz der parallelbetriebenen, symmetrischen Doppelleitung

a) Modell

b) SSK (a&b)r: Summenstromkompensation mit beiden Summenströmen

c) SSK ar: Summenstromkompensation nur mit dem Summenstrom des jeweiligen Systems

Bild 9    Lokaler Stromvergleich bei parallelbetriebener, symmetrischer Doppelleitung

    a) Modell

    b) Strombeträge am Leitungsanfang

    c) Strombeträge am Leitungsende

Bild *10* Stromkorrektur bei parallelbetriebener, mastunsymmetrischer Doppelleitung

a) Ortskurven der Ströme am Leitungsanfang ohne Korrektur

b) Ortskurven der Ströme am Leitungsanfang mit Korrektur

Bild 11   Schaltzustandsabhänig reduzierte Ersatzschaltung der Doppelleitung

a) Symmetrische Ersatzschaltung (nur Nullsystem, für SSK)

b) Unsymmetrische Ersatzschaltung (für LSK)